# EUROPÄISCHE PATENTSCHRIFT

(11) **EP 0 278 223 B1**
(45) Veröffentlichungstag und Bekanntmachung des Hinweises auf die Patenterteilung: **08.04.1992**
(21) Anmeldenummer: 88100198.6
(22) Anmeldetag: 08.01.1988
(51) Int. Cl.: G01R 21/127, G01R 21/00

(54) **Statisches Leistungsmessgerät**
Static power measuring apparatus
Appareil statique pour mesurer la puissance

(30) Priorität: 21.01.1987 DE 3701653
(43) Veröffentlichungstag der Anmeldung: 17.08.1988
(73) Patentinhaber: SIEMENS AKTIENGESELLSCHAFT, 80333 München (DE)
(72) Erfinder: Steinmüller, Günter, Dipl.-Ing., D-8500 Nürnberg (DE); Förder, Walter, Dipl.-Phys., D-8510 Fürth (DE)

(56) Entgegenhaltungen:
- EP-A- 0 161 447
- DE-A- 2 715 321
- DE-B- 2 512 301
- TECHNISCHES MESSEN atm, Band 45, Nr. 11, 1978, Seiten 407-411; G. STEINMÜLLER: "Ein genauer elektronischer Elektrizitätszähler"
- CPEM DIGEST 1978, CONFERENCE ON PRECISION ELECTROMAGNETIC MEASUREMENTS, Seiten 147-148; P.M. LJANIC et al.: "On electronic three-phase active and reactive power measurement"

## Beschreibung

Die Erfindung betrifft ein statisches Leistungsmeßgerät für ein Drehstromnetz mit einem symmetrischen Spannungsdreieck, mit einem Schalter je Phase R,S,T, der zur Zuführung jeweils einer ersten Eingangsgröße U_{R},U_{S},U_{T} dieser Phase R,S,T an eine allen Phasen gemeinsame Auswerteeinheit dient und wobei zur Steuerung jedes Schalters ein Modulator vorgesehen ist, der von einer der jeweiligen Phase R,S,T zugeordneten zweiten Eingangsgröße I_{R},I_{S},I_{T} ansteuerbar ist und der zur Aussendung einer Ausgangs-Impulsfolge vorgesehen ist, deren Tastverhältnis M der zweiten Eingangsgröße I_{R},I_{S},I_{T} proportional ist sowie Verfahren zur Blindleistungsmessung mit dem statischem Leistungsmeßgerät.

Ein derartiges Leistungsmeßgerät ist aus der DE-A-2 715 321 bekannt.

Ein weiterer elektronischer Elektrizitätszähler, dessen Eingangsstufen ein Leistungsmeßgerät darstellen, ist aus "Technisches Messen ATM" 1978, Heft 11, Seiten 407-411 bekannt. Dabei werden Strom und Spannung von jeweils derselben Phase über Strombzw. Spannungswandler einem Multiplizierer je Phase zugeführt. Durch Multiplikation der Augenblickswerte von Strom und Spannung erhält man einen Meßwert für die Wirkleistung. Die Ausgangssignale der Multiplizierer werden zusammen auf einen Quantisierer geführt, der das Eingangssignal in eine Impulsfolge umsetzt, deren Frequenz der Summe der Wirkleistungen in den drei Phasen proportional ist. Dem Quantisierer wird über einen Frequenzteiler ein Zählwerk nachgeschaltet, das die Impulse des Quantisierers nach einer entsprechenden Frequenzteilung aufsummiert und somit die verbrauchte elektrische Arbeit anzeigt. Mit diesem Elektrizitätszähler ist lediglich eine Wirkleistungsmessung bzw. eine Wirkverbrauchsmessung möglich.

Aus der EP-A-00 52 256 ist es bekannt, zur Erfassung der Blindleistung den Strom jeder Phase um -45° und die Spannung derselben Phase um +45° zu verschieben und dann die so phasenverschobenen Größen zu multiplizieren. Die Phasenverschiebung erfolgt dabei mit Allpässen. Am Ausgang des Multiplizierers steht damit ein der Blindleistung proportionales Signal an.

Die für diese Schaltung benötigten Allpässe können jedoch praktisch nicht vollständig auf einer integrierten Schaltung untergebracht werden. Diese Allpässe stehen somit einer Integration der elektronischen Meßschaltung entgegen.

Aufgabe der Erfindung ist es daher, ein statisches Leistungsmeßgerät der eingangs genannten Art so auszuführen, daß auch eine Blindleistungs- bzw. Blindverbrauchsmessung mit einfach zu integrierenden Bauteilen möglich wird.

Diese Aufgabe wird erfindungsgemäß dadurch gelöst, daß zur Blindleistungsmessung die Modulatoren zur Ansteuerung der Schalter jeder Phase R,S,T mit einem Tastverhältnis versehen sind, das der Differenz der aus den zweiten Eingangsgrößen I_{R},I_{S},I_{T} der jeweils beiden anderen Phasen R,S,T abgeleiteten Tastverhältnisse M_{R},M_{S},M_{T} entspricht.

Eine derartige Ansteuerung der Modulatoren kann problemlos in Halbleiterschaltungen integriert werden.

Vorteilhafte Ausgestaltungen der Erfindung sind in den Unteransprüchen angegeben.

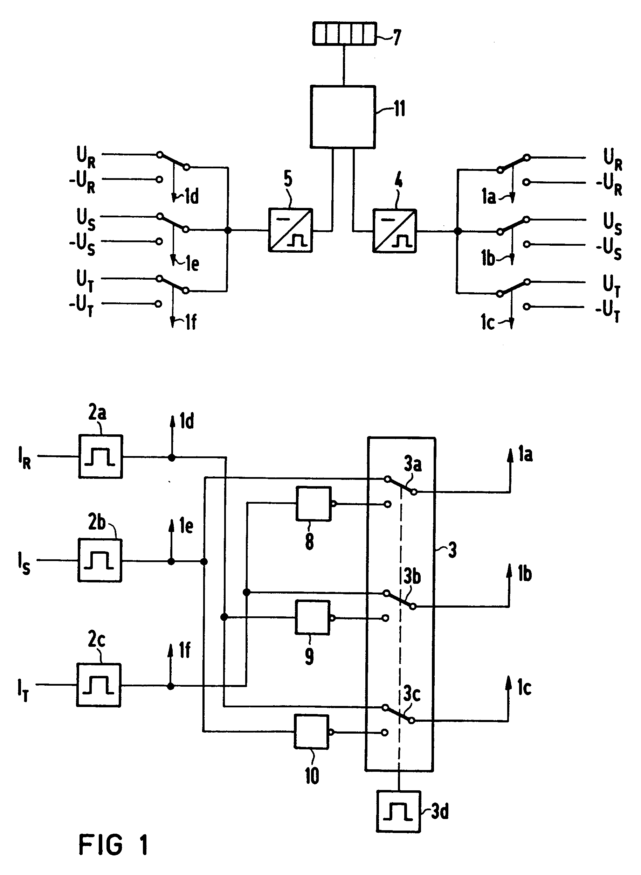

Ausführungsbeispiele der Erfindung werden nachfolgend anhand der FIG 1-3 näher erläutert.

FIG 1 zeigt ein Ausführungsbeispiel für einen statischen Elektrizitätszähler, mit dem sowohl Blind- als auch Wirkverbrauch erfaßt werden kann. Dabei sind für jede Phase zwei Schalter 1a,1d;1b,1e;1c,1f vorgesehen. Jeder der Schalter kann wahlweise auf die jeweilige Phasenspannung U_{R}, U_{S}, U_{T} oder auf die invertierte Phasenspannung -U_{R}, -U_{S}, -U_{T} geschaltet werden. Es ist aber auch möglich, nur die nichtinvertierten Phasenspannungen U_{R}, U_{S}, U_{T} zu schalten, wobei dann jeder Schalter 1a-1f nur einen Schaltkontakt aufweist. Die ersten Schalter 1a-1c jeder Phase sind gemeinsam mit dem Eingang eines Quantisierers 4 und die zweiten Schalter 1d-1f jeder Phase ebenfalls gemeinsam mit einem Quantisierer 5 verbunden. Den Quantisierern 4 und 5 ist eine Rechenschaltung 11 nachgeschaltet, die wiederum eine Anzeigevorrichtung 7 ansteuert.

Je Phase ist ferner ein Modulator 2a-2c vorgesehen, dem eingangsseitig die jeweiligen Phasenströme I_{R}, I_{S}, I_{T} zugeführt werden. Diese Modulatoren steuern die Schalter 1d-1f der jeweils zugeordneten Phase.

Ferner ist ein Multiplexer 3 mit drei Umschaltern 3a-3c vorgesehen. Die Umschalter 3a, 3b, 3c können als digitale Schalter z.B. mit Gattern aufgebaut werden. Die Umschalter 3a, 3b, 3c werden von einem Taktgeber 3d angesteuert, der z.B. auch die Modulatoren 2a, 2b, 2c ansteuern kann. Ein erster Umschaltkontakt des Umschalters 3a ist mit dem Ausgang des Modulators 2b, ein zweiter Umschaltkontakt über einen Inverter 8 mit dem Ausgang des Modulators 2c verbunden. Ein erster Umschaltkontakt des Umschalters 3b ist mit dem Ausgang des Modulators 2c, ein zweiter Umschaltkontakt über einen Inverter 9 mit dem Ausgang des Modulators 2a verbunden. Ein erster Umschaltkontakt des Umschalters 3c ist mit dem Ausgang des Modulators 2a, ein zweiter Umschaltkontakt über einen Inverter 10 mit dem Ausgang des Modulators 2b verbunden.

Vom Festkontakt des Umschalters 3a wird der Schalter 1a der Phase R, vom Festkontakt des Umschalters 3b der Schalter 1b der Phase S und vom Festkontakt des Umschalters 3c der Schalter 1c der Phase T angesteuert.

Durch Ansteuerung der Schalter 1a-1f durch die Modulatoren 2a-2c wird eine Multiplikation von Strom und Spannung nach dem time-division-Verfahren erreicht. Aus den Strömen I_{R}, I_{S}, I_{T} wird mit den Modulatoren 2a-2c jeweils ein Tastverhältnis M gebildet, das dem jeweiligen Strom I proportional ist: 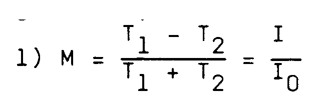
Dabei ist T₁ die Einschaltzeit, T₂ die Ausschaltzeit des jeweiligen Modulators und I₀ ein Referenzstrom.

Die Modulatoren 2a-2c steuern die Schalter 1d-1f so an, daß während der Zeitspanne T₁ die Spannung U mit einem positiven, während der Zeitspanne T₂ mit einem negativen Vorzeichen bewertet wird. Für den Mittelwert P_{M} über die Dauer eines Taktes gilt: 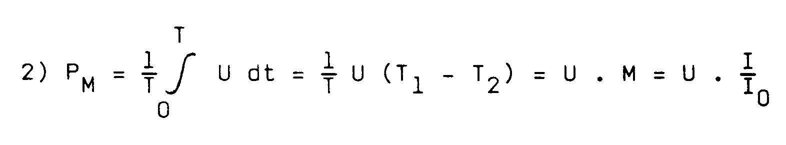
Dabei ist T = T₁ + T₂ die konstante Periodendauer der Ausgangsspannung der Modulatoren, die typischerweise z.B. bei 1 ms liegt. Der Mittelwert P_{M} ist somit dem Produkt von Strom und Spannung proportional.

Die Schalter 1d-1f werden von den Modulatoren 2a-2c so angesteuert, daß jeweils Strom und Spannung derselben Phase multipliziert werden, d.h. daß das Tastverhältnis M_{X} der Phase X immer der Spannung U_{X} der gleichen Phase zugeordnet ist. Durch Aufsummierung über die drei Phasen erhält man somit die Wirkleistung. Für die mittlere Wirkleistung P_{W} über eine Periode mit der Dauer T_{P} gilt: 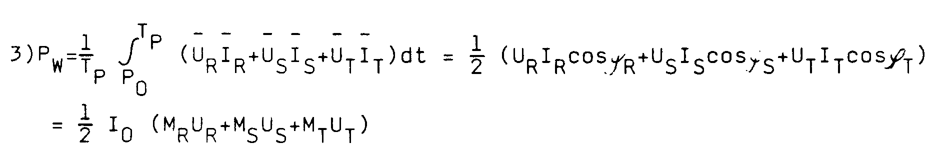
Dabei sind U̅,I̅ Momentanwerte, U,I Amplitudenwerte von Spannung bzw. Strom und M_{R},M_{S},M_{T} die dem Strom I_{S},I_{R},I_{T} der jeweiligen Phase zugeordneten Tastverhältnisse.

Die so erhaltene Wirkleistung wird mit dem Quantisierer 5 in eine Impulsfolge mit einer leistungsproportionalen Frequenz umgesetzt. Dabei kann z.B. das Ladungskompensationsverfahren oder das Kondensatorumladeverfahren eingesetzt werden. Beide Verfahren sind in der bereits erwähnten Literaturstelle "Technisches Messen ATM" 1978, Heft 11, Seiten 407-411 beschrieben. Durch Aufsummierung der Impulse in einer Rechenschaltung 11 erhält man den Wirkverbrauch, der in der Anzeige 7 angezeigt werden kann.

Der bisher beschriebene Schaltungsteil entspricht der in der genannten Literaturstelle beschriebenen Anordnung.

Wie im folgenden erläutert, erreicht man durch die Ansteuerung der Schalter 1a-1c über den Multiplexer 3 eine Erfassung der Blindleistung, so daß man über den Quantisierer 4 und die Rechenschaltung 11 auch den Blindverbrauch bestimmen kann. Dabei wird von einem symmetrischen Spannungsdreieck ausgegangen. Wie im folgenden nachgewiesen, kann man durch eine spezielle Zuordnung zwischen Modulator und Schalter und Invertierung der Tastverhältnisse über gewisse Taktzeiten eine Phasenbeziehung von 90° zwischen Strom und Spannung herstellen und damit anstelle der Wirkleistung die Blindleistung erfassen.

Die mittlere Blindleistung P_{B} über die Periode mit der Dauer T_{P} erhält man durch 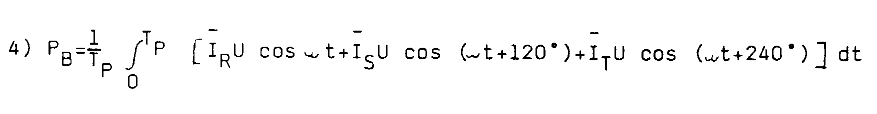
Durch Umformung erhält man daraus: 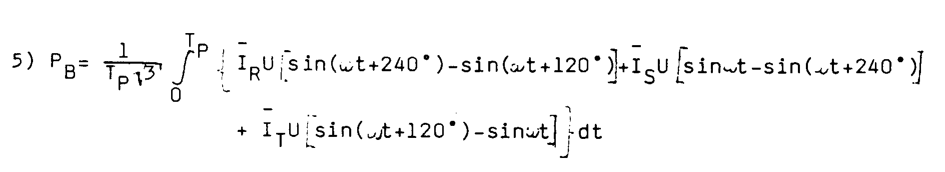
In einem symmetrischen Drehstromsystem lassen sich dafür folgende Momentanwerte U der Spannungen einsetzen: 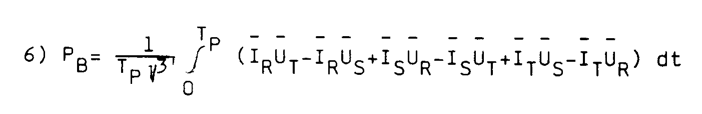
Dabei wird die Tatsache ausgenutzt, daß in einem symmetrischen Drehstromnetz die einzelnen Phasen um 120° gegeneinander versetzt sind.

Wenn man, wie in FIG 1 dargestellt, die Ströme I_{R},I_{S},I_{T} in proportionale Tastverhältnisse M_{R},M_{S},M_{T} umsetzt, so kann man dies umformen in: 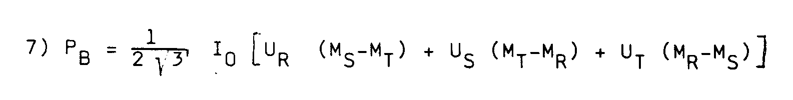
Der Multiplexer 3 nach FIG 1 zusammen mit den Invertern 8-10 realisiert die Differenzbildung der Tastverhältnisse M_{S} - M_{T}, M_{T} - M_{R}, M_{R} - M_{S} gemäß dieser Formel. Die Produktbildung mit den gemäß dieser Formel zugeordneten Strömen erfolgt durch entsprechende Ansteuerung der Schalter 1a-1c, so daß am Eingang des Quantisierers 4 ein Blindleistungs-proportionales Signal ansteht. Durch den Quantisierer 4 wird daraus eine Impulsfolge mit Blindleistungs-proportionaler Frequenz.

Durch Aufintegrierung der Impulse in der Rechenschaltung 11 kann somit der Blindverbrauch ermittelt und in der Anzeige 7 angezeigt werden. Die Rechenschaltung 11 kann so ausgeführt werden, daß wahlweise Blind- oder Wirkverbrauch angezeigt werden. Ferner kann die Rechenschaltung 11 auch aus Wirk- und Blindverbrauch den Scheinverbrauch ermitteln.

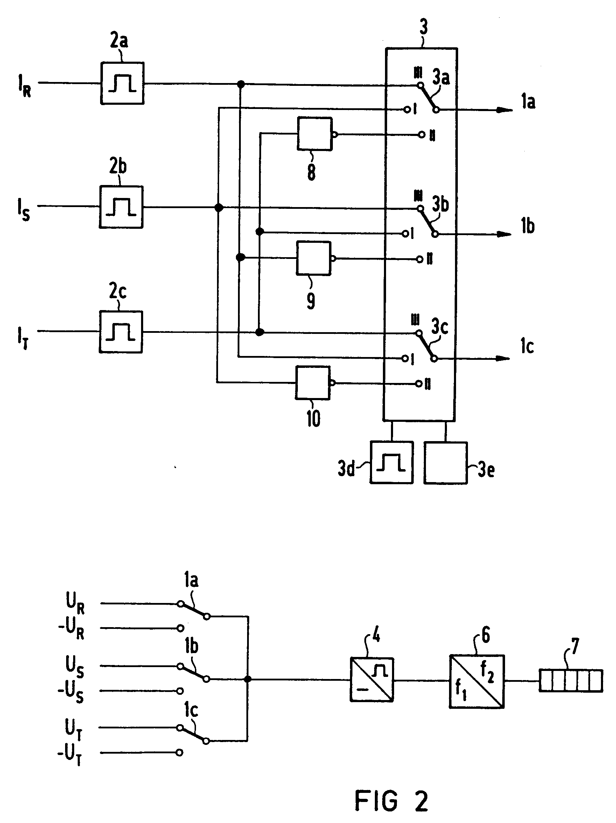

FIG 2 zeigt ein Ausführungsbeispiel, bei dem die Phasenspannungen U_{R},U_{S},U_{T} nur über eine Gruppe von Schaltern 1a-1c geführt werden. Ferner ist auch nur ein Quantisierer 4 vorgesehen, der über einen Frequenzteiler 6 direkt eine Anzeigevorrichtung 7 steuert, die die empfangenen Impulse, z.B. mit einem Rollenzählwerk aufsummiert.

Die Umschalter 3a-3c des Multiplexers 3 weisen jeweils einen zusätzlichen dritten Umschaltkontakt III auf. Die beiden ersten Umschaltkontakte I und II sowie die Festkontakte sind wie beim Ausführungsbeispiel nach FIG 1 geschaltet. Der dritte Umschaltkontakt III des Umschalters 3a ist mit dem Ausgang des Modulators 2a, der dritte Umschaltkontakt III des Umschalters 3b ist mit dem Ausgang des Modulators 2b und der dritte Umschaltkontakt III des Umschalters 3c ist mit dem Ausgang des Modulators 2c verbunden. Durch eine Steuereinheit 3e können die Umschalter 3a-3c so gesteuert werden, daß sie entweder fest auf dem Umschaltkontakt 3 stehenbleiben oder zwischen den Umschaltkontakten I und II hin- und herschalten. Im erstgenannten Betriebsfall sind damit die Modulatoren 2a-2c für die Ströme I_{R},I_{S},I_{T} mit den Steuereingängen für die Schalter 1a-1c der jeweils gleichen Phase verbunden. Damit wird in diesem Betriebsfall der Wirkverbrauch gemessen. Werden dagegen die Umschalter 3a-3c so angesteuert, daß sie zwischen den Schalterstellungen I und II hin- und herschalten, so wird, wie anhand des Ausführungsbeispieles nach FIG 1 erläutert, der Blindverbrauch gemessen. Diese Anordnung hat somit den Vorteil, daß durch Hinzufügen eines einfach zu integrierenden Multiplexers zu einer Zählerschaltung Wirk- oder Blindverbrauch gemessen werden können und daß die Umschaltung zwischen beiden Betriebsarten durch ein einziges Signal erfolgen kann.

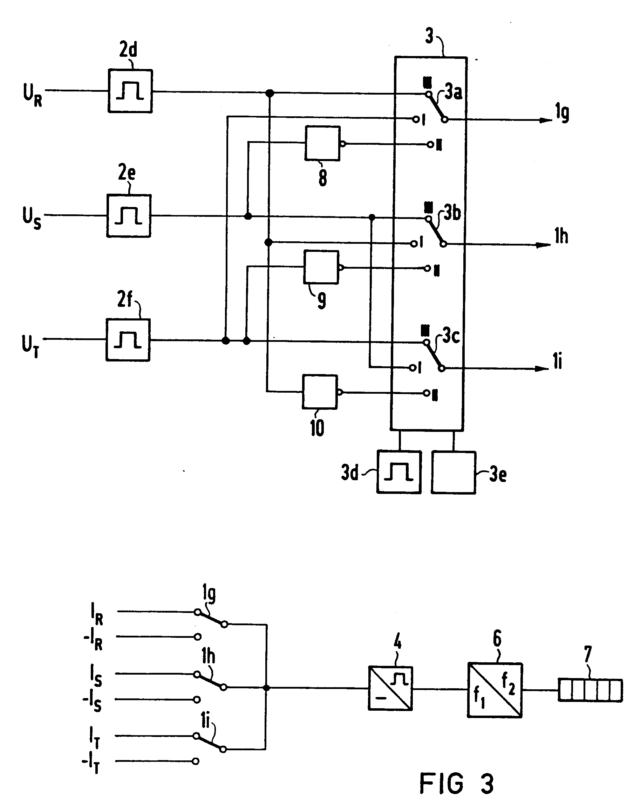

Das Ausführungsbeispiel nach FIG 3 unterscheidet sich von den bisher dargestellten Ausführungsbeispielen dadurch, daß die Phasenspannungen U_{R}, U_{S}, U_{T} Multiplexern 2d-2f und die Phasenströme I_{R}, I_{S}, I_{T} bzw. -I_{R},-I_{S},-I_{T} Umschaltkontakten der Schalter 1g-1i zugeführt werden. Den Schaltern 1g-1i sind wieder ein gemeinsamer Quantisierer 4, ein Frequenzteiler 6 und eine Anzeigevorrichtung 7 nachgeschaltet. Die Modulatoren 2d-2f steuern über den Multiplexer 3 die Schalter 1g-1i. Dabei ist mit dem zweiten Umschaltkontakt II des Umschalters 3a der Ausgang des Modulators 2e der Phase S über einen Inverter 8 verbunden, mit dem ersten Umschaltkontakt I des Umschalters 3a ist der Ausgang des Modulators 2f der Phasenspannung U_{T} verbunden und mit dem dritten Umschaltkontakt III ist der Modulator 2d der Phasenspannung U_{R} verbunden. Mit dem zweiten Umschaltkontakt II des Umschalters 3b ist der Ausgang des Modulators 2f der Phasenspannung U_{T} über einen Inverter 9 verbunden, mit dem ersten Umschaltkontakt I ist der Ausgang des Modulators 2d der Phasenspannung U_{R} verbunden und mit dem dritten Umschaltkontakt III ist der Ausgang des Modulators 2e der Phasenspannung U_{S} verbunden. Mit dem zweiten Umschaltkontakt II des Umschalters 3c ist der Ausgang des Modulators 2d der Phasenspannung U_{R} über einen Inverter 10 verbunden, mit dem ersten Umschaltkontakt I ist der Ausgang des Modulators 2e der Phasenspannung U_{S} verbunden und mit dem dritten Umschaltkontakt III ist der Ausgang des Modulators 2f der Phasenspannung U_{T} verbunden.

Der Festkontakt des Umschalters 3a steuert den Schalter 1g für den Phasenstrom I_{R}, der Festkontakt des Umschalters 3b den Schalter 1h für den Phasenstrom I_{S} und der Festkontakt des Umschalter 3c den Schalter 1i für den Phasenstrom I_{T}.

Wie beim Ausführungsbeispiel nach FIG 2 können die Umschalter 3a-3c durch eine Steuereinheit 3e so angesteuert werden, daß sie entweder fest auf dem dritten Umschaltkontakt III stehen oder zwischen dem ersten und zweiten Umschaltkontakt I, II hin- und herschalten. Im erstgenannten Betriebsfall werden wieder Ströme und Spannungen derselben Phase multipliziert, so daß der Wirkverbrauch ermittelt wird. Im zweitgenannten Betriebsfall wird wiederum der Blindverbrauch erfaßt, was im folgenden nachgewiesen wird:
Wenn man in der Gleichung 6) die Phasenspannungen U_{R}, U_{S}, U_{T} durch proportionale Tastverhältnisse M_{R}, M_{S}, M_{T} ersetzt, so erhält man: 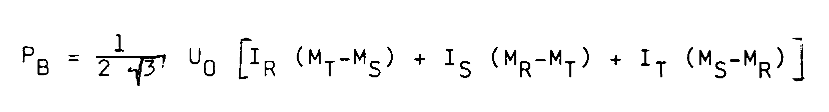
Mit der beschriebenen Schaltung des Multiplexers gemäß FIG 3 werden genau die Differenzen der Tastverhältnisse gemäß dieser Formel gebildet und mit der entsprechenden Phasenspannung U_{R}, U_{S}, U_{T} multipliziert.

## Patentansprüche

1. Statisches Leistungsmeßgerät für ein Drehstromnetz mit einem symmetrischen Spannungsdreieck, mit einem Schalter (1a-1i) je Phase R,S,T, der zur Zuführung jeweils einer ersten Eingangsgröße U_{R},U_{S},U_{T} dieser Phase R,S,T an eine allen Phasen gemeinsame Auswerteeinheit dient und wobei zur Steuerung jedes Schalters (1a-1i) ein Modulator (2a-2c) vorgesehen ist, der von einer der jeweiligen Phase R,S,T zugeordneten zweiten Eingangsgröße I_{R},I_{S},I_{T} ansteuerbar ist und der zur Aussendung einer Ausgangs-Impulsfolge vorgesehen ist, deren Tastverhältnis M der zweiten Eingangsgröße I_{R},I_{S},I_{T} proportional ist,
**dadurch gekennzeichnet,**
daß zur Blindleistungsmessung die Modulatoren (2a-2c) zur Ansteuerung der Schalter (1a-1c) jeder Phase R,S,T mit einem Tastverhältnis versehen sind, das der Differenz der aus den zweiten Eingangsgrößen I_{R},I_{S},I_{T} der jeweils beiden anderen Phasen R,S,T abgeleiteten Tastverhältnisse M_{R},M_{S},M_{T} entspricht.

2. Statisches Leistungsmeßgerät nach Anspruch 1,
**dadurch gekennzeichnet,**
daß ein Multiplexer (3) vorgesehen ist, der je Phase R,S,T einen von einem Taktgeber (3d) gesteuerten Umschalter (3a-3c) aufweist, mit folgenden weiteren Merkmalen:
a) der Festkontakt jedes Umschalters (3a-3c) ist jeweils mit dem Steuereingang des Schalters (1g-1i) der zugeordneten Phase R,S,T verbunden.
b) der erste Umschaltkontakt des Umschalters (3a) der Phase R ist mit einem Modulator (2f) für die Spannung U_{T} der Phase T und der zweite Umschaltkontakt über einen Inverter (8) mit einem Modulator (2e) für die Spannung U_{S} der Phase S verbunden,
c) der erste Umschaltkontakt des Umschalters (3b) der Phase S ist mit einem Modulator (2d) für die Spannung U_{R} der Phase R und der zweite Umschaltkontakt über einen Inverter (9) mit dem Modulator (2f) für die Spannung U_{T} der Phase T verbunden,
d) der erste Umschaltkontakt des Umschalters (3c) der Phase T ist mit dem Modulator (2e) für die Spannung U_{S} der Phase S und der zweite Umschaltkontakt über einen Inverter (10) mit dem Modulator (2d) für die Spannung U_{R} der Phase R verbunden.

3. Statisches Leistungsmeßgerät nach Anspruch 1,
**dadurch gekennzeichnet,**
daß ein Multiplexer (3) vorgesehen ist, der je Phase R,S,T einen von einem Taktgeber (3d) gesteuerten Umschalter (3a-3c) aufweist, mit folgenden weiteren Merkmalen:
a) der Festkontakt jedes Umschalters (3a-3c) ist jeweils mit dem Steuereingang des Schalters (1a-1c) der zugeordneten Phase R,S,T verbunden,
b) der erste Umschaltkontakt des Umschalters (3a) der Phase R ist mit dem Modulator (2b) für den Strom I_{S} der Phase S und der zweite Umschaltkontakt über einen Inverter (8) mit dem Modulator (2c) für den Strom I_{T} der Phase T verbunden,
c) der erste Umschaltkontakt des Umschalters (3b) der Phase S ist mit dem Modulator (2c) für den Strom I_{T} der Phase T und der zweite Umschaltkontakt über einen Inverter (9) mit dem Modulator (2a) für den Strom I_{R} der Phase R verbunden,
d) der erste Umschaltkontakt des Umschalters (3c) der Phase T ist mit dem Modulator (2a) für den Strom I_{R} der Phase R und der zweite Umschaltkontakt über einen Inverter (10) mit dem Modulator (2b) für den Strom I_{S} der Phase S verbunden.

4. Statisches Leistungsmeßgerät nach einem der Ansprüche 2 oder 3, **gekennzeichnet** durch folgende Merkmale:
a) jeder Umschalter (3a-3c) weist einen dritten Umschaltkontakt auf, der mit dem Modulator (2a-2f) der zugeordneten Phase R,S,T verbunden ist,
b) über eine Steuereinheit (3e) sind die Umschalter (3a-3c) so steuerbar, daß sie zur Wirkleistungsmessung auf dem dritten Umschaltkontakt stehenbleiben und zur Blindleistungsmessung die Schaltstellung periodisch zwischen den beiden ersten Umschaltkontakten wechseln.

5. Statisches Leistungsmeßgerät nach einem der Ansprüche 1 bis 4, **dadurch gekennzeichnet,**
daß dem Leistungsmeßgerät zur Verbrauchsmessung ein Quantisierer (4) und ein Zähler (6) nachgeschaltet sind.

6. Statisches Leistungsmeßgerät nach einem der Ansprüche 1 bis 5, **dadurch gekennzeichnet,**
daß je Phase R,S,T ein zusätzlicher Schalter (1d,1e,1f) vorhanden ist, über den die erste Eingangsgröße U_{R},U_{S},U_{T} einer allen Phasen R,S,T gemeinsamen zusätzlichen Auswerteeinheit (5) zugeführt ist, wobei jeder zusätzliche Schalter (1d,1e,1f) vom Modulator (2a,2b,2c) der zugeordneten Phase angesteuert wird.

7. Statisches Leistungsmeßgerät nach Anspruch 6,
**dadurch gekennzeichnet,**
daß beiden Auswerteeinheiten (4,5) eine gemeinsame Recheneinheit (11) nachgeschaltet ist, die wahlweise Wirk-, Blind-oder Scheinverbrauch ermittelt.

8. Verfahren zur Blindleistungsmessung mit dem statischen Leistungsmeßgerät nach Anspruch 1 oder 2, wobei in jeder Phase R,S,T der Strom I_{R}, I_{S}, I_{R} die erste Eingangsgröße und die Spannung U_{R}, U_{S}, U_{T} die zweite Eingangsgröße ist,
**gekennzeichnet** durch folgende Merkmale:
a) der Schalter (1g) der Phase R wird gesteuert durch das der Spannung U_{T} der Phase T entsprechenden Tastverhältnis M_{T}, minus dem der Spannung U_{S} der Phase S entsprechenden Tastverhältnis M_{S},
b) der Schalter (1h) der Phase S wird gesteuert durch das der Spannung U_{R} der Phase R entsprechende Tastverhältnis M_{R} minus dem der Spannung der Phase T entsprechenden Tastverhältnis M_{T},
c) der Schalter (1i) der Phase T wird gesteuert durch das der Spannung S entsprechende Tastverhältnis M_{S} minus dem der Spannung der Phase R entsprechenden Tastverhältnis M_{R},

9. Verfahren zur Blindleistungsmessung mit dem statischen Leistungsmeßgerät nach Anspruch 1 oder 3, wobei bei jeder Phase R,S,T die Spannung U_{R}, U_{S}, U_{T} die erste Eingangsgröße und der Strom I_{R}, I_{S}, I_{T} die zweite Eingangsgröße ist,
**gekennzeichnet** durch folgende Merkmale:
a) der Schalter (1a) der Phase R wird gesteuert durch das dem Strom I_{S} der Phase S entsprechende Tastverhältnis M_{S} minus dem dem Strom I_{T} der Phase T entsprechenden Tastverhältnis M_{T},
b) der Schalter (1b) der Phase S wird gesteuert durch das dem Strom I_{T} der Phase T entsprechende Tastverhältnis M_{T} minus dem dem Strom I_{R} der Phase R entsprechenden Tastverhältnis M_{R},
c) der Schalter (1c) der Phase T wird gesteuert durch das den Strom I_{R} der Phase R entsprechende Tastverhältnis M_{R} minus dem dem Strom I_{S} der Phase S entsprechende Tastverhältnis M_{S}.

10. Verfahren nach Anspruch 8 oder 9,
**dadurch gekennzeichnet,**
daß bei Rückspeisung von Leistung in ein Netz die Ansteuerung der Schalter (1a-1i) invertiert wird.

11. Verfahren nach einem der Ansprüche 8 bis 10,
**dadurch gekennzeichnet,**
daß die Umschalter (3a-3c) von einem Takt gesteuert werden, der direkt einem Takt der Modulatoren (2a-2c) entspricht oder daraus abgeleitet ist.

## Claims

1. Static power-measuring device for a three-phase system with a symmetrical voltage triangle, having a switch (1a-1i) for each phase R,S,T, which serves to supply in each case a first input variable U_{R},U_{S},U_{T} of this phase R,S,T to an evaluation unit common to all phases and whereby to control each switch (1a-1i) a modulator (2a-2c) is provided, which is controllable by a second input variable I_{R},I_{S},I_{T}, associated with the respective phase R,S,T, and which is provided for the emission of an output pulse sequence, whose mark-space ratio M is proportional to the second input variable I_{R},I_{S},I_{T},
characterized in that for reactive-power measurement the modulators (2a-2c) to control the switches (1a-1c) of each phase R,S,T are provided with a mark-space ratio which corresponds to the difference of the mark-space ratios M_{R},M_{S},M_{T} derived from the second input variables I_{R},I_{S},I_{T} of the two other phases R,S,T respectively.

2. Static power-measuring device according to claim 1, characterized in that a multiplexer (3) is provided, which for each phase R,S,T has a change-over switch (3a-3c) controlled by a clock generator (3d), having the following further features:
a) the fixed contact of each change-over switch (3a-3c) is connected in each case to the control input of the switch (1g-1i) of the associated phase R,S,T,
b) the first change-over contact of the change-over switch (3a) of the phase R is connected to a modulator (2f) for the voltage U_{T} of the phase T and the second change-over contact is connected by means of an inverter (8) to a modulator (2e) for the voltage U_{S} of the phase S,
c) the first change-over contact of the change-over switch (3b) of the phase S is connected to a modulator (2d) for the voltage U_{R} of the phase R and the second change-over contact is connected by means of an inverter (9) to the modulator (2f) for the voltage U_{T} of the phase T,
d) the first change-over contact of the change-over switch (3c) of the phase T is connected to the modulator (2e) for the voltage U_{S} of the phase S and the second change-over contact is connected by means of an inverter (10) to the modulator (2d) for the voltage U_{R} of the phase R.

3. Static power-measuring device according to claim 1, characterized in that a multiplexer (3) is provided, which for each phase R,S,T has a change-over switch (3a-3c) controlled by a clock generator (3d), having the following further features:
a) the fixed contact of each change-over switch (3a-3c) is connected in each case to the control input of the switch (1a-1c) of the associated phase R,S,T,
b) the first change-over contact of the change-over switch (3a) of the phase R is connected to the modulator (2b) for the current I_{S} of the phase S and the second change-over contact is connected by means of an inverter (8) to the modulator (2c) for the current I_{T} of the phase T,
c) the first change-over contact of the change-over switch (3b) of the phase S is connected to the modulator (2c) for the current I_{T} of the phase T and the second change-over contact is connected by means of an inverter (9) to the modulator (2a) for the current I_{R} of the phase R,
d) the first change-over contact of the change-over switch (3c) of the phase T is connected to the modulator (2a) for the current I_{R} of the phase R and the second change-over contact is connected by means of an inverter (10) to the modulator (2b) for the current I_{S} of the phase S.

4. Static power-measuring device according to one of claims 2 or 3, characterized by the following features:
a) each change-over switch (3a-3c) has a third change-over contact, which is connected to the modulator (2a-2f) of the associated phase R,S,T,
b) by means of a control unit (3e) the change-over switches (3a-3c) can be controlled in such a way that for active-power measurement they remain on the third change-over contact and for reactive-power measurement they change the switching position periodically between the two first change-over contacts.

5. Static power-measuring device according to one of claims 1 to 4, characterized in that a quantizer (4) and a counter (6) are connected in series with the power-measuring device for measurement of consumption.

6. Static power-measuring device according to one of claims 1 to 5, characterized in that for each phase R,S,T an additional switch (1d,1e,1f) is present, by means of which the first input variable U_{R},U_{S},U_{T} is supplied to an additional evaluation unit (5) common to all phases R,S,T, whereby each additional switch (1d,1e,1f) is controlled by the modulator (2a,2b,2c) of the associated phase.

7. Static power-measuring device according to claim 6, characterized in that a common calculation unit (11) is connected in series with the two evaluation units (4, 5), which determines selectively active, reactive or apparent consumption.

8. Process for reactive-power measurement with the static power-measuring device according to claim 1 or 2, whereby in each phase R,S,T the current I_{R}, I_{S}, I_{R} is the first input variable and the voltage U_{R}, U_{S}, U_{T} is the second input variable, characterized by the following features:
a) the switch (1g) of the phase R is controlled by the mark-space ratio M_{T}, corresponding with the voltage U_{T} of the phase T, minus the mark-space ratio M_{S} corresponding with the voltage U_{S} of the phase S,
b) the switch (1h) of the phase S is controlled by the mark-space ratio M_{R}, corresponding with the voltage U_{R} of the phase R, minus the mark-space ratio M_{T} corresponding with the voltage of the phase T,
c) the switch (1i) of the phase T is controlled by the mark-space ratio M_{S}, corresponding with the voltage S, minus the mark-space ratio M_{R} corresponding with the voltage of the phase R.

9. Process for reactive-power measurement with the static power-measuring device according to claim 1 or 3, whereby at each phase R,S,T the voltage U_{R}, U_{S}, U_{T} is the first input variable and the current I_{R}, I_{S}, I_{T} is the second input variable,
characterized by the following features:
a) the switch (1a) of the phase R is controlled by the mark-space ratio M_{S}, corresponding with the current I_{S} of the phase S, minus the mark-space ratio M_{T} corresponding with the current I_{T} of the phase T,
b) the switch (1b) of the phase S is controlled by the mark-space ratio M_{T}, corresponding with the current I_{T} of the phase T, minus the mark-space ratio M_{R} corresponding with the current I_{R} of the phase R,
c) the switch (1c) of the phase T is controlled by the mark-space ratio M_{R}, corresponding with the current I_{R} of the phase R, minus the mark-space ratio M_{S} corresponding with the current I_{S} of the phase S.

10. Process according to claim 8 or 9, characterized in that with feedback of power into a system the control of the switches (1a-1i) is inverted.

11. Process according to one of claims 8 to 10, characterized in that the change-over switches (3a-3c) are controlled by a clock pulse, which corresponds directly with a clock pulse of the modulators (2a-2c) or is derived therefrom.

## Revendications

1. Appareil statique de mesure de puissance pour un réseau triphasé à triangle symétrique de tension, comportant un commutateur (1a-1i) pour chaque phase R,S,T, qui sert à envoyer respectivement une première grandeur d'entrée U_{R},U_{S},U_{T} de cette phase R,S,T à une unité d'évaluation commune à toutes les phases, et dans lequel, pour la commande de chaque commutateur (1a-1i), il est prévu un modulateur (2a-2c), qui peut être commandé par une seconde grandeur I_{R},I_{S},I_{T}, associée à la phase respective R,S,T et est prévu pour l'envoi d'une suite d'impulsions de sortie, dont le taux d'impulsions M est proportionnel à la seconde grandeur d'entrée I_{R},I_{S},I_{T}, caractérisé par le fait
que pour la mesure de la puissance réactive, les modulateurs (2a-2c) possèdent, pour la commande des commutateurs (1a-1c) de chaque phase R,S,T, un taux d'impulsions qui correspond à la différence entre les taux d'impulsions M_{R},M_{S},M_{T} dérivés des deux grandeurs d'entrée I_{R},I_{S},I_{T} des deux autres phases respectives R,S,T.

2. Appareil statique de mesure de puissance suivant la revendication 1, caractérisé par le fait qu'il est prévu un multiplexeur (3) qui possède, pour chaque phase R,S,T, un commutateur (3a-3c) commandé par un générateur de cadence (3d), avec les autres caractéristiques suivantes :
a) le contact fixe de chaque commutateur (3a-3c) est raccordé respectivement à l'entrée de commande du commutateur (1g-1i) de la phase R,S,T associée;
b) le premier contact de commutation du commutateur (3a) de la phase R est raccordé à un modulateur (2f) pour la tension U_{T} de la phase T et le second contact de commutation est raccordé par l'intermédiaire d'un inverseur (8) à un modulateur (2a) pour la tension U_{S} de la phase S,
c) le premier contact de commutation du commutateur (3b) de la phase S est raccordé à un modulateur (2d) pour la tension U_{R} de la phase R et le second contact de commutation est raccordé par l'intermédiaire d'un inverseur (9) au modulateur (2f) pour la tension U_{T} de la phase T,
d) le premier contact de commutation du commutateur (3c) de la phase T est raccordé au modulateur (2e) pour la tension U_{S} de la phase S et le second contact de commutation est raccordé par l'intermédiaire d'un inverseur (10) au modulateur (2d) pour la tension U_{R} de la phase R.

3. Appareil statique de puissance suivant la revendication 1, caractérisé par le fait qu'il est prévu un multiplexeur (3), qui, pour chaque phase R,S,T, possède un commutateur (3a-3c) commandé par un générateur de cadence (3d), avec les autres caractéristiques suivantes :
a) le contact fixe de chaque commutateur (3a-3c) est raccordé respectivement à l'entrée de commande du commutateur (1a-1c) de la phase R,S,T associée,
b) le premier contact de commutation du commutateur (3a) de la phase R est raccordé au modulateur (2b) pour le courant I_{S} de la phase S et le second contact de commutation est raccordé par l'intermédiaire d'un inverseur (8) au modulateur (2c) pour le courant I_{T} de la phase T,
c) le premier contact de commutation du commutateur (3b) de la phase S est raccordé au modulateur (2c) pour le courant I_{T} de la phase T et le second contact de commutation est raccordé par l'intermédiaire d'un inverseur (9) au modulateur (2a) pour le courant I_{R} de la phase R,
d) le premier contact de commutation du commutateur (3c) de la phase T est raccordé au modulateur (2a) pour le courant I_{R} de la phase R et le second contact de commutation est raccordé par l'intermédiaire d'un inverseur (10) au modulateur (2b) pour le courant I_{S} de la phase S.

4. Appareil statique de mesure de puissance suivant la revendication 2 ou 3, caractérisé par les particularités suivantes :
a) chaque commutateur (3a-3c) possède un troisième contact de commutation, qui est raccordé au modulateur (2a-2f) de la phase R,S,T associée,
b) les commutateurs (3a-3c) peuvent être commandés par l'intermédiaire d'une unité de commande (3e) de telle sorte qu'ils restent sur le troisième contact de commutation pour effectuer la mesure de la puissance active et modifient périodiquement leur position de commutation entre les deux premiers contacts de commutation, pour la mesure de la puissance réactive.

5. Appareil statique de mesure de puissance suivant l'une des revendications 1 à 4, caractérisé par le fait qu'un quantificateur (4) et un compteur (6) sont branchés en aval de l'appareil de mesure de puissance, pour réaliser la mesure de la consommation.

6. Appareil statique de mesure de puissance suivant la revendication 5, caractérisé par le fait que pour chaque phase R,S,T, il est prévu un commutateur supplémentaire (1d,1e,1f), au moyen duquel la première grandeur d'entrée U_{R},U_{S},U_{T} est envoyée à une unité d'évaluation supplémentaire (5) commune à toutes les phases R,S,T, chaque commutateur supplémentaire (1d,1e,1f) étant commandé par le modulateur (2a,2b,2c) de la phase associée.

7. Appareil statique de mesure de puissance suivant la revendication 6, caractérisé par le fait qu'en aval des deux unités d'évaluation (4,5) est branchée une unité de calcul commune (11), qui détermine au choix la consommation active, réactive ou apparente.

8. Procédé de mesure de la puissance réactive comportant un appareil statique de mesure de puissance suivant la revendication 1 ou 2, selon lequel dans chaque phase R,S,T, le courant I_{R},I_{S},I_{T} est la première grandeur d'entrée, et la tension U_{R},U_{S},U_{T} est la seconde grandeur d'entrée,
caractérisé par les particularités suivantes :
a) le commutateur (1g) de la phase R est commandé par le taux d'impulsions M_{T}, qui correspond à la tension U_{T} de la phase T, diminué du taux d'impulsions M_{S} qui correspond à la tension U_{S} de la phase S,
b) le commutateur (1h) de la phase S est commandé par le taux d'impulsions M_{R}, qui correspond à la tension U_{R} de la phase R, diminué du taux d'impulsions M_{T} qui correspond à la tension de la phase T,
c) le commutateur (1i) de la phase T est commandé par le taux d'impulsions M_{S} qui correspond à la tension S, diminué du taux d'impulsions M_{R} qui correspond à la tension de la phase R.

9. Procédé de mesure de la puissance réactive comportant un appareil statique de mesure de la puissance suivant la revendication 1 ou 3, et selon lequel, dans chaque phase R,S,T, la tension U_{R},U_{S},U_{T} représente la première grandeur d'entrée et le courant I_{R},I_{S},I_{T} représente la seconde grandeur d'entrée, caractérisé par les particularités suivantes :
a) le commutateur (1a) de la phase R est commandé par le taux d'impulsions M_{S} qui correspond au courant I_{S} de la phase S, diminué du taux d'impulsions M_{T} qui correspond au courant I_{T} de la phase T,
b) le commutateur (1b) de la phase S est commandé par le taux d'impulsions M_{T} qui correspond au courant I_{T} de la phase T, diminué du taux d'impulsions M_{R} qui correspond au courant I_{R} de la phase R,
c) le commutateur (1c) de la phase T est commandé par le taux d'impulsions M_{R} qui correspond au courant I_{R} de la phase R, diminué du taux d'impulsions M_{S} qui correspond au courant I_{S} de la phase S.

10. Procédé suivant la revendication 8 ou 9, caractérisé par le fait que lors de l'injection en retour d'une énergie dans un réseau, la commande des commutateurs (1a-1i) est inversée.

11. Procédé suivant l'une des revendications 8 à 10, caractérisé par le fait que les commutateurs (3a-3c) sont commandés par une cadence qui correspond directement à une cadence du modulateur (2a-2c) ou en est dérivée.
